# EUROPÄISCHE PATENTSCHRIFT

(11) **EP 0 321 663 B1**
(45) Veröffentlichungstag und Bekanntmachung des Hinweises auf die Patenterteilung: **15.09.1993**
(21) Anmeldenummer: 88116306.7
(22) Anmeldetag: 01.10.1988
(51) Int. Cl.: H02H 9/04, H03K 17/08, H02P 7/29

(54) **Schaltungsanordnung zum Schutz eines Schalttransistors**
Protection circuitry for a commutating transistor
Circuit de protection d'un transistor de communication

(30) Priorität: 23.12.1987 DE 3743866
(43) Veröffentlichungstag der Anmeldung: 28.06.1989
(73) Patentinhaber: Lenze GmbH & Co. KG Aerzen, D-31855 Aerzen (DE)
(72) Erfinder: Karl, Heinz-Dietmar, Dipl.-Ing., D-4924 Barntrup (DE); Tinebor, Manfred, Dipl.-Ing., D-4924 Barntrup (DE); Lackhove, Josef, Dipl.-Ing., D-3258 Aerzen 1 (DE)
(74) Vertreter: Elbertzhagen, Otto

(56) Entgegenhaltungen:
- DE-A- 3 525 942
- US-A- 4 658 203

## Beschreibung

Die Erfindung bezieht sich auf eine Schaltungsanordnung zum Schutz eines Schalttransistors, der im Gattungsbegriff des Patentanspruchs 1 näher bezeichneten Art.

Bei Schalttransistoren wird die Durchbruchspannung so bemessen, daß sie im Normalfall von der anliegenden Versorgungsspannung zuzüglich der entstehenden Schaltspannung durch Leitungs- und Streuinduktivitäten nicht überschritten wird. Es wäre jedoch unwirtschaftlich, die Durchbruchspannung von Schalttransistoren so groß zu wählen, daß noch die höchste je auftretende Überspannung unterhalb der Durchbruchspannung bleibt. Man muß deshalb Schutzschaltungen vorsehen, über die auftretende Überspannungen, die größer als die Durchbruchspannung sind, abgeleitet werden, um den Schalttransistor vor solchen gelegentlich auftretenden Überspannungen zu schützen.

Dazu ist es bekannt, parallel zum Schalttransistor Spannungsbegrenzerbauelemente, wie Varistoren oder Zenerdioden, anzuordnen. Solche Spannungsbegrenzerbauelemente müssen groß dimensioniert werden, um energiereiche Überspannungspulse aufzunehmen und die entstehende Verlustleistung abführen zu können.

Im Hinblick auf die Dimensionierung der Bauteile der Schutzschaltung ist es vorteilhafter, den Transistor mittels einer Zenerdiode oder einem Varistor bei auftretenden Überspannungen einzuschalten. Denn hierfür sind nur kleine Spannungsbegrenzerbauelemente erforderlich, da die Energie der Überspannungspulse vom Transistor selbst aufgenommen wird. Der Schalttransistor ist in der Regel in der Lage, größere Verlustleistungen abzuführen, als es die Spannungsbegrenzerbauelemente können.

Letztlich hat aber auch der Schalttransistor nur ein begrenztes Vermögen, die bei Überspannungen entstehende Verlustleistung abzuführen. So können Überspannungen, die für längere Zeit anstehen, wenn z.B. die Versorgungsspannung direkt netzspannungsabhängig ist, zur Zerstörung des Schalttransistors führen.

Um aufgrund einer solchen Dauerbeanspruchung mit Überspannung eine Zerstörung des Transistors zu vermeiden, ist es ferner bekannt, die Überspannung durch eine Messeinrichtung zu erfassen. Bei Überschreiten eines maximalen Spannungspegels wird eine Impulssperre des Pulsbreitenmodulators ausgelöst, wonach der Schalttransistor nicht mehr angesteuert wird und ein erneutes Einschalten des Transistors verhindert ist. Infolge dessen wird die Spannung am Schalttransistor um die Schaltspannung reduziert. Zwar wird durch diese zusätzliche Maßnahme eine Überlastung des Schalttransistors bei länger andauernder Versorgungsüberspannung, die durch die ständige aktive Begrenzung der Schaltspannung entstehen würde, sicher vermieden, nachteilig dabei ist jedoch, daß ein solcher Störfall zu einer vollständigen Abschaltung führt. Wird z.B. über den Schalttransistor ein Gleichstrommotor versorgt, führte der beschriebene Überspannungsfall jeweils zum Stillsitzen des Antriebs. In den meisten Einsatzfällen ist dies nicht akzeptabel.

Aufgabe der Erfindung ist es daher, eine Schaltungsanordnung der eingangs genannten Art zu schaffen, die einerseits den Schalttransistor aktiv und zuverlässig vor Überspannungen schützt, andererseits im Überlastungsfall ein vollständiges Abschalten vermeidet.

Diese Aufgabe wird nach der Erfindung durch die kennzeichnenden Merkmale des Patentanspruchs 1 gelöst.

Die Erfindung beruht also auf dem Gedanken, bei andauernder Überspannung der Versorgungsspannung den Schalttransistor weiter schalten zu lassen, jedoch die entstehende Schaltspannung zu reduzieren. Da die Höhe der Schaltspannung bei konstanter Schaltzeit von der Höhe des Stromes durch die Leitungs- bzw. Streuinduktivitäten abhängig ist, wird die Schaltspannung durch die Reduzierung des Stromes verringert. Man erreicht dies durch die Einflußnahme auf den Pulsbreitenmodulator, welcher im Störfalle durch das zusätzlich gewonnene Regelsignal derart angesteuert wird, daß das Puls- Pause-Verhältnis, mit dem der Schalttransistor angesteuert wird, verringert wird.

Die Erfindung wird nachfolgend anhand der Zeichnung an Ausführungsbeispielen noch näher erläutert. Dabei zeigen:
- Fig. 1:: Das Schaltbild einer Schaltungsanordnung zum Schutz eines Schalttransistors in einer ersten, einfachen Ausführungsform und
- Fig. 2:: das Schaltbild einer Schaltungsanordnung der vorgenannten Art bei einem Motorstromregler,
- Fig. 3:: ein Diagramm zur Veranschaulichung der Abhängigkeit des Motorstromes von der Höhe der statischen Netzspannung bei der Schaltungsanordnung nach Fig. 2 und
- Fig. 4:: die Darstellung der Spannung am Schalttransistor bei verschiedenen Netzspannungen entsprechend der Arbeitspunkte A bis D in Fig. 3.

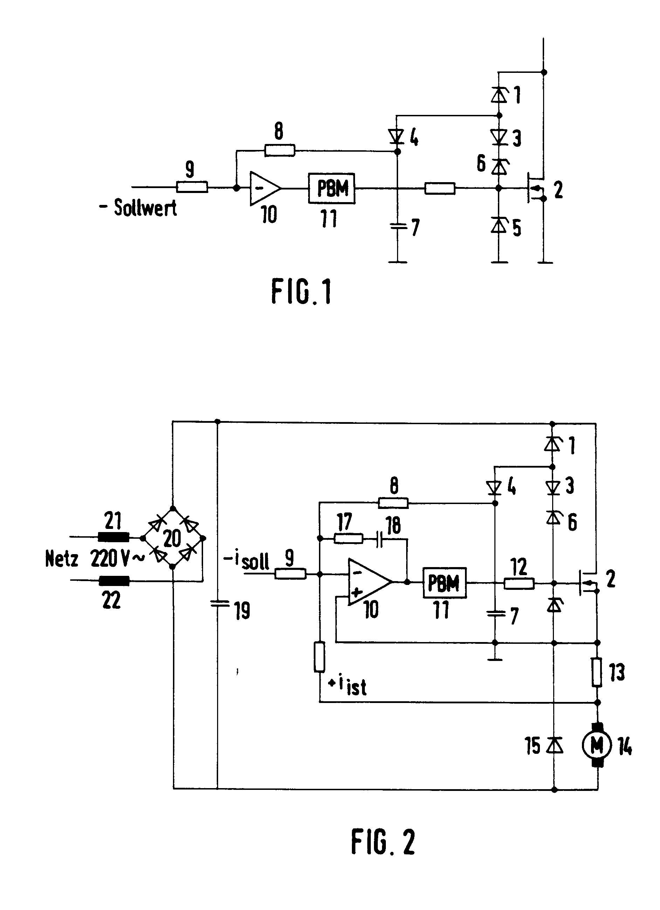

Im einzelnen zeigt Fig. 1 ein Ausführungsbeispiel für die Schutzschaltungsanordnung eines Schalttransistors, wie sie in einem Schaltnetzteil eingesetzt werden kann. Am Eingangszweig eines Schalttransistors 2 ist als Spannungsbegrenzungsbauglied eine Zenerdiode 1 mit ihrer Katode angeschlossen, die anodenseitig über eine Diode 4 mit einem Kondensator 7 verbunden ist. Zwischen dem Kondensator 7 und der Diode 4 ist ein Leitungszweig mit einem Entladewiderstand 8 angeschlossen, der zu einem Summationspunkt am Eingang eines Stromreglers 10 führt. Dieser Summationspunkt ist über einen Widerstand 9 mit einem Sollwertgeber verbunden. Aus dem Sollwertsignal und der Spannung, die über den Entladewiderstand 8 an dem Summationspunkt anliegt, wird eine Differenzspannung gebildet, die auf den Stromregler gegeben wird. Ausgangsseitig ist der Stromregler 10 mit dem Steuereingang eines Pulsbreitenmodulators 11 verbunden, der ausgangsseitig am Steuereingang des Schalttransistors 2 anliegt.

Weiter ist die Zenerdiode 1 mit ihrer Anode über eine Diode 3 und eine zweite Zenerdiode 6 unmittelbar unter Umgehung des Pulsbreitenmodulators 11 auf den Steuereingang des Schalttransistors 2 geschaltet. Der Steuereingang des Schalttransistors 2 ist über eine weitere Zenerdiode 5 mit dem Masse-Potential verbunden.

Bei einer auftretenden Überspannung wird die Zenerdiode 1 als Spannungsbegrenzerdiode leitend. Der durch die Spannungsbegrenzerdiode 1 fließende Strom lädt über die Diode 4 den Kondensator 7 auf. Über den Entladewiderstand 8 verringert der Entladestrom des Kondensators das Puls-Pause-Verhältnis des Pulsbreitenmodulators 11. Hierdurch wird mit den nächstfolgenden Taktzyklen der Schaltstrom durch den Schalttransistor 2 und damit die Schaltspannung reduziert. Wird die Entladezeitkonstante des Kondensators 7 sehr groß gegenüber der Taktperiodendauer gewählt, stellen sich entsprechend der Höhe der statischen Versorgungsüberspannung stabile Arbeitspunkte ein.

Bei kurzen, energiereichen Überspannungspulsen wird der Kondensator 7 schneller geladen, als der Strom in der Last durch Verändern des Puls-Pause-Verhältnisses verringert werden kann. In diesem Fall wird der Schalttransistor über die Diode 3 und die Zenerdiode 6 angesteuert. Die Überspannung wird durch den Schalttransistor 2, der im angesteuerten Zustand leitend ist, selbst begrenzt. Die Durchbruchsspannung der Zenerdiode 6 ist so bemessen, daß sich der Kondensator 7 soweit aufladen kann, bis das Puls-Pause-Verhältnis des Pulsbreitenmodulators 11 Null wird, wenn der Schalttransistor 2 zur dynamischen Überspannungsbegrenzung eingeschaltet wird. Durch die lange Entladezeitkonstante des Kondensators 7 wird dem Schalttransistor 2 eine Erholzeit gegeben, um die bei der Überspannungsbegrenzung aufgenommene Verlustleistung abzuführen.

Fig. 2 zeigt eine analoge Schaltungsanordnung an einem 20KHz Motorstromregler. Der grundsätzliche Aufbau und die Funktion dieser Schaltungsanordnung ist der nach Fig. 1 gleich. Der Motor 14 wird aus dem Netz über eine Gleichrichterbrücke 20 und den Schalttransitor 2 gespeist. Über den Strommeßwiderstand 13 wird der Motorstrom erfaßt und vom Stromregler 10 auf den vorgegebenen Sollwert geregelt. Bei Netzüberspannung wird auch hier über die Begrenzerdiode 1 und die Diode 4 mittels des Kondensators 7 ein Regelsignal gebildet, welches über den Entladewiderstand 8 auf den Summationspunkt des Stromreglers gegeben wird. Dadurch reduziert der Stromregler 10 den Motorstrom gerade soweit, daß eine maximale Spannung am Schalttransistor 2 nicht überschritten wird.

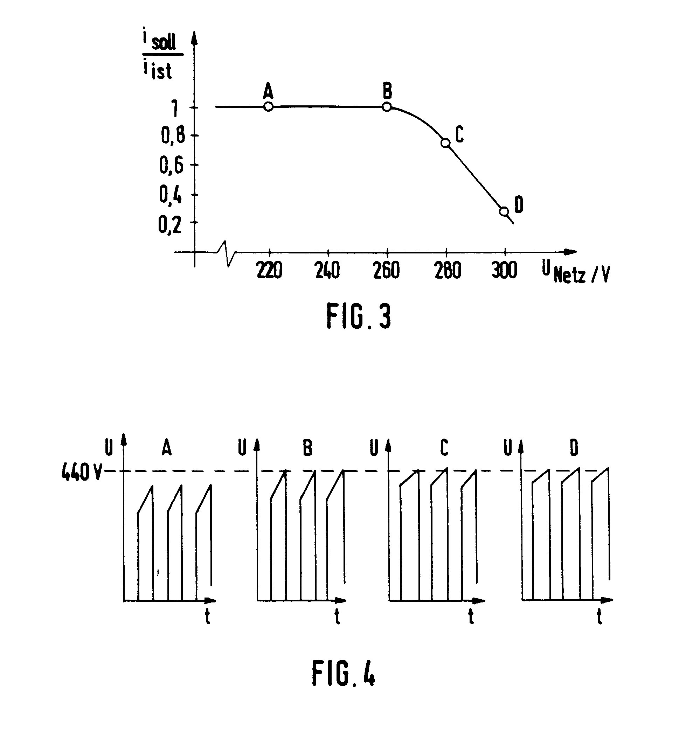

Fig. 3 zeigt dazu die Abhängigkeit des Motorstromes von der Höhe der statischen Netzspannung, die sich bei der Schaltungsanordnung nach Fig. 2 ergibt. Als Begrenzerdiode wurde eine Diode mit 440 V Durchbruchspannung verwendet. Folglich kann der Motor bis zu einer Netzspannung von 260 V mit maximalem Strom versorgt werden. Bei einer weiteren Steigerung der Netzspannung wird der Motorstrom durch die vorbeschriebene Schaltungsanordnung reduziert. Zu den jeweiligen Arbeitspunkten A - D in Fig. 3 ist in Fig. 4 die Spannung am Schalttransistor 2 bei den jeweiligen Netzspannungen dargestellt. Daraus erkennt man, daß bei Netzspannungen über 260 V hinaus der Motorstrom gerade soweit abgeregelt wird, daß die Spannung am Schalttransistor der Durchbruchsspannung von 440 V der Zenerdiode 1 entspricht.

Es wird also durch die Reduzierung des Motorstromes bei höher werdender Netzspannung der Anteil der Schaltspannung reduziert. Die Maximalspannung am Schalttransistor 2 wird auf einem konstanten Wert gehalten.

Der entscheidende Vorteil bei der Anwendung der vorbeschriebenen Schaltungsanordnung liegt darin, daß bei der Motorstromregelung für die Dauer der Netzüberspannung lediglich der Motorstrom und damit das Motordrehmoment reduziert wird. Eine Überlastung des Schalttransistors 2 einerseits sowie ein Stillsetzen des Antriebes andererseits wird mit dieser Schaltungsanordnung vermieden.

## Patentansprüche

1. Schaltungsanordnung zum Schutz eines Schalttransistors (2), der zwischen einer Gleichspannungsquelle und einer induktiven Last (14) angeordnet ist, mit einem steuerbaren Pulsbreitenmodulator (11), der den Schalttransistor (2) ansteuert, und mit einem Spannungsbegrenzungsbauelement (1), das bei auftretenden Überspannungen ein Einschalten des Transistors (2) bewirkt,
dadurch gekennzeichnet,
daß mittels des Spannungsbegrenzerbauelementes (1) zusätzlich ein Regelsignal gewonnen wird, das an den Steuereingang des Pulsbreitenmodulators (11) derart angelegt wird, daß das Puls-Pause-Verhältnis des Pulsbreitenmodulators (11) bei Überspannungen verringert wird.

2. Schaltungsanordnung nach Anspruch 1,
dadurch gekennzeichnet,
daß das Regelsignal durch Spitzenwertbildung der des Spannungsbegrenzerbauelementes (1) übersteigenden Spannung gebildet wird.

3. Schaltungsanordnung nach Anspruch 1 und 2,
dadurch gekennzeichnet,
daß der Schalttransistor (2) erst eingeschaltet wird, wenn das Regelsignal einen vorgegebenen Spannungswert überschreitet.

4. Schaltungsanordnung nach einem der Ansprüche 1 bis 3,
dadurch gekennzeichnet,
daß das Spannungsbegrenzerelement (1) eine Zenerdiode ist, deren Katode am Eingangszweig des Schalttransistors (2) liegt und deren Anode mit einem Kondensator (7) verbunden ist, welcher über einen Entladewiderstand (8) mit dem Steuereingang des Pulsbreitenmodulators (11) verbunden ist.

5. Schaltungsanordnung nach Anspruch 4,
dadurch gekennzeichnet,
daß dem Pulsbreitenmodulator (11) ein Stromregler (10) vorgeschaltet ist, an dessen Eingang ein Summationspunkt gebildet ist, an dem der Entladezweig des Kondensators (7) und ein Sollwertsignalgeber anliegen.

6. Schaltungsanordnung nach Anspruch 4 oder 5,
dadurch gekennzeichnet,
daß die Anode des Spannungsbegrenzerelementes (1) über eine weitere Zenerdiode (6) mit dem Steuereingang des Schalttransistors (2) unmittelbar verbunden ist.

7. Schaltungsanordnung nach Anspruch 6,
dadurch gekennzeichnet,
daß die Durchbruchspannung der weiteren Zenerdiode (6) im Anodenzweig des Spannungsbegrenzungselementes (1) so bemessen ist, daß sich der Kondensator (7) bis zur Erreichung eines Puls-Pause-Verhältnisses = 0 des Pulsbreitenmodulators (11) auflädt.

## Claims

1. Circuit arrangement for protecting a switching transistor (2) which is mounted between a direct voltage source and an inductive load (14) with a controllable pulse width modulator (11) which controls the switching transistor (2), and with a voltage restrictor element (1) which in the event of excess voltages occurring causes the transistor (2) to switch on,
characterised in that by means of the voltage restrictor element (1) additionally a regulator signal is obtained which is connected into the control input of the pulse width modulator (11) so that the pulse-pause ratio of the pulse width modulator (11) is reduced in the event of excess voltages.

2. Circuit arrangement according to claim 1 characterised in that the regulator signal is formed by the peak value formation of the voltage which exceeds the voltage restrictor element (1).

3. Circuit arrangement according to claims 1 and 2 characterised in that the switching transistor (2) is only switched in when the regulator signal exceeds a predetermined voltage value.

4. Circuit arrangement according to one of claims 1 to 3 characterised in that the voltage restrictor element (1) is a Zener diode whose cathode lies at the input branch of the switching transistor (2) and whose anode is connected to a capacitor (7) which is connected by a discharge resistance (8) to the control input of the pulse width modulator (11).

5. Circuit arrangement according to claim 4 characterised in that a current regulator (10) is connected into the inlet side of the pulse width modulator (11) wherein at the input of the current regulator a summation point is formed adjoined by the discharge branch of the capacitor (7) and an ideal value signal transmitter.

6. Circuit arrangement according to claims 4 to 5 characterized in that the anode of the voltage restrictor element (1) is directly connected to the control input of the switching transistor (2) by a further Zener diode (6).

7. Circuit arrangement according to claim 6, characterised in that the breakdown voltage of the further Zener diode (6) is measured in the anode branch of the voltage restrictor element (1) so that the capacitor (7) is charged up until reaching a pulse-pause ratio = 0 of the pulse width modulator (11).

## Revendications

1. Circuit de protection d'un transistor de commutation (2), disposé entre une source de tension continue et une charge inductive (14), avec un modulateur d'impulsions en durée 11, qui excite le transistor de commutation (2), et avec un élément limiteur de tension (1), qui provoque la connexion du transistor (2) en cas de surtension,
caractérisé par le fait
qu'un signal de régulation est généré, en plus, à l'aide de l'élément limiteur de tension (1) et transmis à l'entrée de commande du modulateur d'impulsions en durée (11) de sorte que le rapport impulsion-intervalle du modulateur d'impulsions en durée (11) se trouve réduit en cas de surtension.

2. Circuit de protection selon revendication 1,
caractérisé par le fait
que le signal de régulation est formé par maximalisation de la tension qui dépasse l'élément limiteur de tension (1).

3. Circuit de protection selon revendications 1 et 2,
caractérisé par le fait
que le transistor de commutation (2) n'est mis en circuit que lorsque le signal de régulation dépasse une valeur de tension prédéfinie.

4. Circuit de protection selon l'une des revendications 1 à 3,
caractérisé par le fait
que l'élément limiteur de tension (1) est un zéner, dont la cathode est raccordée à la branche d'entrée du transistor de commutation (2) et l'autre anode à un condensateur (7), qui est relié à l'entrée de commande du modulateur d'impulsions en durée (11).

5. Circuit de protection selon revendication 4,
caractérisé par le fait
qu'un régulateur de courant (10) est couplé en amont du modulateur d'impulsions en durée (11), régulateur de courant (10) à l'entrée duquel un point de totalisation est formé et que la branche de décharge du condensateur (7) et un générateur de signal de valeur de consigne sont conduits à ce point de totalisation.

6. Circuit de protection selon revendication 4 ou 5,
caractérisé par le fait
que l'anode de l'élément limiteur de tension (1) est reliée, directement, à l'entrée de commande du transistor de commutation (2) par un autre zéner (6).

7. Circuit de protection selon revendication 6,
caractérisé par le fait
que la tension d'avalanche de l'autre zéner (6), dans la branche d'anode de l'élément limiteur de tension (1), est mesurée de sorte que le condensateur (7) se charge jusqu'à l'obtention d'un rapport impulsion-intervalle = 0 du modulateur (11).
